(19) Europäisches Patentamt
European Patent Office
Office européen des brevets

(11) Publication number : **0 227 871 B1**

(12) **EUROPEAN PATENT SPECIFICATION**

(45) Date of publication of patent specification : **30.11.94 Bulletin 94/48**

(51) Int. Cl.$^5$ : **H03M 1/72**

(21) Application number : **85430046.4**

(22) Date of filing : **30.12.85**

(54) **Parallel algorithmic digital to analog converter.**

(43) Date of publication of application : **08.07.87 Bulletin 87/28**

(45) Publication of the grant of the patent : **30.11.94 Bulletin 94/48**

(84) Designated Contracting States : **DE FR GB IT**

(56) References cited :
**DE-A- 2 612 204**
**NACHRICHTENTECHNIK-ELEKTRONIK, vol. 28, no. 5, 1978, pages 193-196, Berlin, DD;ECKHARDT et al.: "Digital-Analog- und Analog-Digital-Umsetzer auf der Basis von Ladungsteilungen"**
**IEEE INTERNATIONAL SOLID-STATE CIRCUITS CONFERENCE, San Francisco, US, 22nd - 24th February 1984, vol. 27, pages 62,63, 318, IEEE, New York, US; P.W.LI et al.: "A ratio-independent algorithmic A/D conversion technique"**

(73) Proprietor : **International Business Machines Corporation**
**Old Orchard Road**
**Armonk, N.Y. 10504 (US)**
(84) **DE GB IT**
Proprietor : **Compagnie IBM FRANCE**
**5 Place Vendôme**
**F-75000 Paris 1er (FR)**
(84) **FR**

(72) Inventor : **Czarniak, Jean-Christophe**
**1027, Chemin des Espinets**
**F-06570 Saint-Paul (FR)**
Inventor : **Jacquart, Christian**
**1600, Chemin de Provence**
**F-06510 Gattieres (FR)**
Inventor : **Ferry, Michel François**
**52 Allée des Micocouliers**
**Hameau de Puissanton**
**F-06 620 Vallauris (FR)**

(74) Representative : **Schuffenecker, Thierry et al**
**Compagnie IBM France,**
**Département de Propriété Intellectuelle**
**F-06610 La Gaude (FR)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Jouve, 18, rue Saint-Denis, 75001 PARIS

## Description

### Technical Field

The invention relates to a digital-to-analog converter for converting N-bit digital words into their analog representations.

### Background Art

Conventional digital-to-analogic converters (DAC) include a binary-weighted resistor network (eg. the commonly used R, 2R ladder network), switches, a reference current or voltage source and a summing device. The resistor network produces binary-weighted currents or voltages that can be switched to ON or OFF in accordance with the digital input word. Those binary-weighted currents or voltages drive the summing device which provides, at last, the analog representation of the digital input word. That kind of converter needs a complex circuitry which takes up a substantial amount of space. In addition, to reach a good degree of precision, the network must include a large number of precise resistors; the absolute accuracy of the resistors in the R, 2R ladder is not critical, but their ratio is; that large number of precise components will increase the cost of the DAC. Moreover, since precise resistors, or adjustable resistors are difficult to be placed into a chip, those conventional converters are not suitable to be used into full integrated structures.

Another kind of DAC, based on an algorithmic process, considers one bit at a time in the conversion processing. This reduces the complexity of the circuit, and the number of precise components necessary. However, the number of steps of a conversion cycle tends to slow the analogizing operation, increases the conversion time and thus, decreases the overall efficiency of the analog conversion process.

DE-A1-2,612,204 describes a digital-to-analog converter which involves the use of a serie of weighted capacitors, whereby n bits of a digital words are divided into groups of m bits, and each group is converted in parallel. This converter has the drawback of necessitating accurate components.

Nachrichtentechnik-Elektronik, Vol. 28, No. 5, 1978, pages 193-196, Berlin, DD; Eckhardt et al. : "Digital-Analog und Analog-Digital-Umsetzer auf der Basis von Ladungsteilungen" describes an digital-to-analog converter which allows, in order to reduce the number of conversion steps, the simultaneous conversion of two bits at a time, thereby using weighted capacitances.

IEEE International Solid-state Circuits Conference, San Francisco, US, 22nd-24th February 1984, Volume 27, pages 62, 63, 318; PW Li et al. : "A ratio-independent algorithmic A/D conversion technique" document describes a A/D converter using an accurate multiply-by-2 operator. However that converter requires a great number of steps in order to perform the conversion of one digital word.

### Summary of the Invention

It is an object of the invention to provide a relatively simple and compact DAC, which operates in a multiplexing way and thus reduces the number of components and elementary operators (As described later, a possible way to carry out the invention needs only two operators, a divide by 4 circuit and a multiply by 2 circuit).

Another object of the invention is to provide a low cost converter since the multiplexing process reduces the number of precise and expensive components.

A further object of the invention is to provide a converter easy to integrate into full integrated circuits, since the number of precise or adjustable components is considerably reduced and therefore less difficult to locate in chips.

Another object of the invention is to provide an efficient DAC, with a short conversion time. This results from its characteristics of splitting the N bits into sections, which permits reducing considerably the number of steps of a conversion cycle and allows a quick conversion process.

In conclusion, the invention permits combining good efficiency (a short time conversion) with a simple and compact circuit. These and other objects of the invention will become apparent from the following description of embodiments of the invention.

These objects are achieved by means of the digital-analog conversion method of the invention for converting a B(N)B(N-1)...B1B0 digital word into its analog representation as claimed.

### Description of the Drawings

Fig. 1 is a chart illustrating the basic concept of the invention.

Fig. 2 and 2b are more sophisticated flow charts according to the invention.

Fig. 3 describes an embodiment for carrying out the method of the invention.
Fig. 4 is a progress chart detailing the different steps of the conversion process.
Fig. 5a, 5b, 5c and 5d detail the process for providing an accurate multiply-by-two operator.
Fig. 6a, 6b, 6c and 6d detail the process for providing an accurate divide-by-four operator.
Fig. 7a and 7b detail the steps of an sample/hold function.

## Disclosure of the Invention

Figure 1 is a chart illustrating the basic concept of the invention. Let us call N the number of bits of a digital word; in the following we will suppose that N=12. The 12 bits of a digital word are split into 2 sections, odd bits and even bits. For instance in the following word:

$$B_{11} - B_{10} - B_9 - \ldots\ldots\ldots\ldots - B_1 - B_0$$

$B_{10}$, $B_8$, $B_6$, ..., $B_0$ are called even bits and the others are called odd bits.

Let us define other variables;

| | |
|---|---|
| j : | integer used as a counter |
| $V_p$, $V_p'$ : | voltage which is the analog representation of even bits |
| $V_{out}$ : | output voltage |
| $V_i$, $V_i'$ : | voltage representative of odd bits |
| $V_{ref}$ : | reference voltage |

$V_i'$ and $V_p'$ represent voltages $V_i$ and $V_p$, respectively, which were generated in the previous step.

The algorithm begins by initiating variables i and p, step 1

$$j = 0$$
$$V_i = 0$$
$$V_p = 0$$

The Least Significant Bit (LSB) is decoded first; the variable j is incremented, step 2. Then the value of j is tested to determine whether each bit has been converted, step 3. If not, the bit $B_{j-1}$ is inserted, step 4. Then the character of that bit $B_{j-1}$ is tested, step 5. If $B_{j-1}$ is an "even" bit, the process goes on with step 6 in which the operation $V_p = (V_p' + B_{j-1} \times V_{ref})/4$ is processed; otherwise it is the operation $V_i = (V_i' + B_{j-1} \times V_{ref})/4$ which is processed, step 7. Then the process goes back to step 2 to increment again the variable j.

When the last bit $B_{11}$ has been converted (i.e. j=12) the process goes to step 8 to process a multiplication by 2 affecting the value of $V_p$ and then step 9 provides the analog representation $V_{out} = V_i + V_p$ of the digital word. The advantages offered by such a way of processing consists in the low number of operators necessary to provide the analog representation of the digital word, in our example : a divide by 4 operator, a multiply by 2 operator (which can be easily replaced by an adder operator) and an adder operator.

That will result in an ease in designing the converter and the possibility to combine a high accuracy with a low cost circuit since few precise components are required.

A more sophisticated algorithm based on the same concept is shown in the flow charts of figures 2a and 2b. The sequence begins with step 109 which is a text of the character of the number of bits N of the digital word. If N is an even integer, the sequence progresses to step 110 which initiates variables j, $V_i$ and $V_p$. Then, step 111, the counter j is incremented. Bits $b_{2j-1}$ and $b_{2j-2}$ to be converted are inserted, step 112. Bit $b_{2j-1}$ is tested to determine whether it is the most significant bit (MSB), step 113. If not, the process goes to steps 114 and 115 in which bits $b_{2j-2}$ and $b_{2j-1}$ are converted simultaneously. Then the process goes back to step 111 again. As soon as the last bit inserted $b_{2j-1}$ is the MSB, the sequence progresses from step 113 to steps 117 and 118 in which the calculations $V_p = (V_p' + b_{2j-2} \times V_{ref})/4$ and $V_i = (V_i' + MSB \times V_{ref})$ are processed. The sequence progresses from step 117 to step 118 which is a multiplication by 2 affecting the value of $V_p$. The step following steps 118 and 119 is step 219 shown in figure 2b and connected by arrow 120.

If N is an odd integer, the sequence progresses from step 109 to step 210 shown in figure 2b; that step initiates variables j, $V_i$, $V_p$. Then, step 211, the counter j is incremented. Bit $b_{2j-2}$ is inserted, step 212; this bit is tested to determine whether it is the MSB, step 213. If not, bit $b_{2j-1}$ is inserted step 214. Then the sequence progresses to steps 215 and 216 in which bits $b_{2j-2}$ and $b_{2j-1}$ are converted simultaneously.

Then, the process goes back to step 211 again. As soon as the last bit inserted $b_{2j-2}$ is the MSB, the sequence progresses from step 213 to steps 217 and 218 in which the calculations $V_p = (V_p' + MSB \times V_{ref})$ and $V_i = V_i' \times 2$ are processed.

The sequence progresses from steps 119, 120 and 217, 218 to step 219 which is an addition of $V_i$ and $V_p$ to provide $V_{out}$. Then the sign of the digital word is taken into account to provide an output voltage positive or negative. Step 221 is the end of the conversion.

As a conclusion, the main idea is to convert 2 bits at the same time, one "odd" bit and one "even" bit.

This allows a minimization of the number of steps necessary for the conversion cycle and results in the reducing of the final conversion time.

Figure 3 describes an embodiment corresponding to the flow chart of figures 2a and 2b. That circuit presents the characteristic to include high precision operators. Indeed, since few operators are required to make up an embodiment of the invention (in figure 1, only a divide by 4 circuit and a multiply by 2 circuit are required), it might be sensible and interesting to use high precision operators, such as described later (figure 5 and 6) and which permit to obtain a simple, compact, low cost and accurate converter. Moreover, using further described exact operators will allow the electronic designer to include the converter in full integrated structures since it needs no precise or adjustable components.

The schematic of figure 3 includes 3 blocks, each one devoted to a precise function. The first block 100 is made up of: an operational amplifier (OA) 31, 2 capacitors 32 and 33, switches 30, 32, 35, 36, 37, 38, 39 and 40.Block 200 is identical to block 100, it consists of an OA 41, 2 capacitors 42 and 43, switches 42, 45, 46, 47, 48, 49, 50 and 51. Block 300 includes: an OA 56, a capacitor 52, switches 53, 54 and 55. Blocks 100 and 200 are devoted to process the following basic functions: voltage addition, precise multiplication by 2 and precise division by 4. Block 300 is a sample-hold module which allows to track the analogic signal provided by the block 100 and then holds its instantaneous value while the block 100 begins the next operation. Blocks 100, 200 and 300 are completely described further.

Figure 4 is a progress chart, according to the flow chart of figures 2a and 2b which details the different steps of a conversion cycle: the chart describes, step by step, the state of each switch. The number of N bits of the word is assumed to be even.

Step 401 to 404 initiate the conversion process by treating the first 2 bits B1 and B2:

In step 401, switches 34, 36, 40, 44, 46, 50, 53, 54, 55 are OFF (state 0). The state of switches 30 and 35 depends on the value of the first bit B0, the boolean expressions are:

$$\text{state of switch 30} = B0$$
$$\text{state of switch 35} = \overline{B0}$$

Likewise, the state of switches 45 and 51 depends on the value of the second bit B1, the boolean expressions are:

$$\text{state of switch 45} = \overline{B1}$$
$$\text{state of switch 51} = B1$$

The other switches are ON (state 1). That step permits to process the first 2 bits and begins the division by 4 of $B_0 x V_{ref}$ in block 100 and the division by 4 of $B_1 x V_{ref}$ in block 200.

In step 402, switches 30, 34, 35, 37, 39, 44, 45, 47, 49, 51, 53, 54, and 55 are OFF (state 0); the other switches are ON (state 1).

In step 403, switches 30, 34, 36, 38, 39, 44, 46, 48, 49, 51, 53, 54, and 55 are OFF (state 0); the other switches are ON (state 1).

In step 404, switches 30, 34, 35, 37, 39, 44, 45, 47, 49, 51 and 54 are OFF (state 0); the other switches are ON (state 1). That step permits the transfer of $B_0 x V_{ref}/4$ from block 100 to the Sample/hold block 300, and ends the division by 4.

Step 405 to 412 make up an elementary processing cycle which allow the conversion of 2 following bits $B_{2j-2}$ and $B_{2j-1}$ (j=2 to 5), accordingly to step 14 and 15 of figure 2.

In step 405, switches 30, 35, 36, 40, 44, 45, 47, 49, 51, 53 and 55 are OFF (state 0); the other switches are ON (state 1). That step allows the transfer of the voltage $V_i$ from block 200 to the block 100.

In step 406, switches 30, 34, 36, 37, 39, 45, 46, 50, 51, 53 and 55 are OFF (state 0); the other switches are ON (state 1). That step allows the transfer of the voltage $V_p$ from block 300 to block 200.

In step 407, switches 34, 36, 38, 39, 44, 46, 47, 49, 51, 53, 54 and 55 are OFF (state 0); The state of switches 30 and 35 depends on the value of bit $B_{2j-1}$, the boolean expressions are:

$$\text{state of switch 30} = B_{2j-1}$$
$$\text{state of switch 35} = \overline{B}_{2j-1}$$

the other switches are ON (state 1). That step allows the addition of $B_{2j-1}$ x $V_{ref}$ with the voltage $V_i$ which has been injected step 5 in block 100.

In step 408, switches 30, 34, 35, 37, 40, 44, 46, 48, 49 and 54 are OFF (state 0); The state of switches 45 and 51 depends on the value of bit $B_{2j-2}$, the boolean expressions are:

$$\text{state of switch 45} = \overline{B}_{2j-2}$$
$$\text{state of switch 51} = B_{2j-2}$$

the other switches are ON (state 1). This step allows the addition of $B_{2j-1} x V_{ref}$ with the voltage $V_p$ which has been injected step 6 in block 200. This step also permits transfers of the voltage ($V_i' + B_{2j-1} x V_{ref}$) from block 100 into the block 300.

In step 409, switches 30, 35, 36, 40, 44, 45, 47, 50, 51, 53 and 55 are OFF (state 0); the other switches are ON (state 1). That step ends the addition process in block 200 and transfers the voltage ($V_p' + B_{2j-2} x V_{ref}$)

from block 200 into the block 100 to begin a new division by 4 cycle.

In step 410, switches 30, 34, 35, 37, 39, 45, 46, 50, 51, 53 and 55 are OFF (state 0); the other switches are ON (state 1). That step carries out the transfer of ($V_i'$ + $B_{2j-1}xV_{ref}$) from block 300 into block 200 to begin a division by 4 cycle. This step is also the second phase of the division by 4 of the voltage ($V_p'$ + $B_{2j-2}xV_{ref}$) in block 200.

In step 411, switches 30, 34, 36, 38, 39, 44, 45, 47, 49, 51, 53, 54 and 55 are OFF (state 0); the other switches are ON (state 1). That step is the second phase of the division by 4 of ($V_i'$ + $B_{2j-1}xV_{ref}$) in block 200 and the third phase of the division by 4 of the voltage ($V_p'$ + $B_{2j-2}xV_{ref}$) in block 100.

In step 412, switches 30, 34, 35, 37, 39, 44, 46, 48, 49, 51 and 54 are OFF (state 0); the other switches are ON (state 1). That step is the end of the division by 4 in the 100 and the transfer of the voltage ($V_p'$+ $B_{2xj-2}xV_{ref}$) from block 100 into 300. This step is also the third phase of the division by 4 of ($V_i'$ + $B_2x_{j-1}xV_{ref}$) in block 200.

Then the counter j is incremented and steps 5 to 12 are repeated till j=6 (the last bits to be converted are the MSB and the sign bit). When j=6 the sequence progresses to step a.

In step a, switches 30, 35, 36, 40, 44, 45, 47, 49, 51, 53 and 55 are OFF (state 0); the other switches are ON (state 1). That step is the holding of $V_i$ in the 300 and the transfer of Vp in block 100 (first phase of an addition).

In step b, switches 30, 34, 36, 37, 39, 45, 46, 50, 51, 53 and 55 are OFF (state 0); the other switches are ON (state 1). That step is the beginning of a multiplication by 2 in the block 200 and the second phase of the addition in block 100.

In step c, switches 34, 36, 38, 39, 44, 46, 47, 49, 51, 53 and 55 are OFF (state 0); The state of switches 30 and 35 depends on the value of the bit MSB, the boolean expressions are:

state of switch 30 = MSB
state of switch 35 = MSB

the other switches are ON (state 1). That step allows the addition of the voltage corresponding to the MSB in block 100 and produces the second phase of the multiplication by 2 in block 100.

In step d, switches 30, 34, 36, 37, 39, 45, 46, 48, 49, 51, 53 and 55 are OFF (state 0); the other switches are ON (state 1). That step is the third phase of the multiplication by 2 in block 200 and the end of the addition of the MSB into the block 100.

In step e, switches 30, 35, 36, 38, 39, 44, 45, 47, 50, 51, 53, 54 and 55 are OFF (state 0); the other switches are ON (state 1). That step is the end of the multiplication by 2 of the odd values and the addition of that result to even values in block 100.

In step f, switches 30, 34, 35, 37, 40, 44, 45, 46, 47, 48, 49, 50, 51, 53, 54 and 55 are OFF (state 0); the other switches are ON (state 1). That step is the output of the final value $2xV_p+V_i$.

The sign bit is taken into account simply by replacing each addition by a substration; this takes one more clock cycle for each bit because an substration needs one more clock cycle than an addition.

Figure 5a, 5b, 5c and 5d details the process which permits the block 100 (and 200) to operate a precise multiplication by 2. That operation is also described in the literature (1984 IEEE - ISSCC Wednesday, February 22, 1984).

That block 100 includes an operational amplifier (OA) 31 (figure 3) which has its first input connected to the ground and its second input connected to a first terminal of switches 37, 38, and capacitor 32. The second terminal of capacitor 32 is connected to a first terminal of switches 30, 34, 35 and 36. The second terminals of switches 30, 34, 35 and 36 are connected respectively to bias voltage $V_{ref}$, the output of the OA 41, the ground and the output of the OA 31. The second terminals of switches 37 and 38 are connected respectively to the output of the OA 31 and the first terminal of switches 39 and 40. The second terminals of switches 40 and 39 are connected respectively to the output of the OA 31 and the ground. Let us make the following assumptions:

- The OA 31 has an offset called off
- C32 and C33 are the numerical value of the capacitors 32 and 33 different only by the mismatching between the 2 capacitors.
- The following relation can be written:
  C33 = (1+E). C32, wherein E is the coefficient representative of the mismatching of the 2 capacitors.
- $V_{out}$ is the output voltage of the OA 31

When switches, 34, 37, 38 and 39 are ON, and the other switches are OFF, the schematic of block 100 in figure 3 is equivalent to the scheme of figure 5a. That step realizes a first sampling of the input voltage and an offset cancel:

Indeed, capacitor 32 is first charged to the input voltage minus the OA 31 offset, while capacitor 33 is charged to the OA 31 offset.

When switches 35, 38, 40 are ON, and the other ones are OFF, the schematic of block 100 is equivalent to the schematic of figure 5b ; the feedback loop is opened, capacitor 33 is connected to the OA 31 output, and capacitor 32 is disconnected from the source $V_{in}$ and connected to the ground;

C32 is discharged and its charge is transferred to C33.

When switches 34, 37, 40 are ON, and the other ones are OFF, the schematic of block 100 is equivalent to the schematic of figure 5c : capacitor 33 is disconnected from the summing node to maintain the previous charge in it and the input in resampled again with 32;

When switches 36, 38, 39 are ON, and the others ones are OFF, the schematic of block 100 is equivalent to the schematic of figures 5d : the charge on the capacitor 33 is dumped again on 32 in addition to the charge which has just been sampled in figure 5-c.

This provides an output which is twice the input voltage, independent of the ratio of the capacitors (at the second order relative to the unmatching of the capacitors). The sequence requires 4 clock steps to complete.

Block 200 is identical with block 100.

A characteristic of this embodiment of the invention is that the block 100 (and 200) is used again to provide a accurate division by 4 process. However, the states of the switches in the steps of a division cycle is different than previously.

Figures 6a, 6b, 6c and 6d describe the 4 steps which permit to provide the division by 4 process.

When switches 34, 37, 38 and 39 are ON, and the other switches are OFF, the block 100 is equivalent to the schematic of figure 6a. That step realizes as before, a first sampling of the input voltage and an offset cancel:

When switches 36, 38 and 40 are ON, and the other switches are OFF, the block 100 is equivalent to the scheme of figure 6b. That step realizes a redistribution of charge from capacitor 32 to capacitor 33. The output voltage is:

$$V_{out} = V_{in} / (2 + E)$$

When switches 35, 37 and 40 are ON, and the other switches are OFF, the block 100 is equivalent to the schematic of figure 6c. That step realizes a holding of previous charge in capacitor 33 and a discharge of capacitor 32.

When switches 36, 38 and 40 are ON, and the other switches are OFF, the block 100 is equivalent to the schematic of figure 6d . That step realizes a second transfer of charge from capacitor 33 to 32. The output voltage is then:

$$V_{out} = (V_{in} / 4) \times \frac{(1 + E)}{(1 + E/2)^2}$$

The expansion in TAYLOR's series of $\frac{(1 + E)}{(1 + E/2)^2}$ shows that this function is of second order relative to E.

In conclusion, the input voltage has been divided accurately by 4 (at the second order relative to E), without any error introduced by the mismatching of capacitors. The offset of the operational amplifier is cancelled during the cycle

Figure 7a and 7b describes the well known process which permits block 300 to operate a Sample-hold function, e.g. taking an input signal and then holding its instantaneous value.

That block 300 includes an operational amplifier 56 (figure 3) which has its first input connected to the ground and its second input connected to a first terminal of switch 53 and capacitor 52. The second terminal of capacitor 52 is connected to first terminal of switch 55 and switch 54. The second terminal of switch 55 and 54 are connected respectively to the output of the OA 31 and the output of the OA 56. The second terminal of switch 53 is connected to the output of the OA 56 and the terminal of switch 44.

When switch 54 is OFF (state 0) and the other ones are ON (state 1) block 300 is equivalent to the schematic of figure 7a. That step provides a first sampling of the input voltage $V_{in}$.

When switch 53 and 55 are OFF (state 0) and the other ones are ON (state 1) block 300 is equivalent to the schematic of figure 7b. That step holds the instantaneous value of $V_{in}$ which has been sampled in figure 7a.

It should be noticed that the circuit described below may be advantangeously implemented with full differential operational amplifiers, having each two inputs and two outputs. Indeed, such a structure would increase the signal/noise ratio and would permit processing sign stem 220 more easily. That implementation is obvious for who is skilled in the art.

## Claims

**1.** A digital-to-analog conversion method for converting an N-bit digital word (B(N-1)B(N-2)...N1B0) into its analog representation, with N being an even integer, said digital word consisting of a first sequence of odd bits B(2j-1) and a second sequence of even bits B(2j-2), where j=1 to N/2, the conversion of an odd bit and the conversion of an even bit being parallely performed, said method involving the steps of:

- detecting (113) whether the odd bit (B(2j-1) among the two bits being parallely converted is the Most Significant Bit (MSB),
- as long as the odd bit to be converted is not the most significant bit, generating (115) a first sequence of analog voltages Vi satisfying the following relationship Vi=(Vi′ + B(2j-1)xVref)/4, said first sequence of analog values being representative of the conversion of the odd bits, and Vref being a reference voltage; and parallely generating (114) a second sequence of analog voltages Vp satisfying the relation ship Vp = ( Vp′ + B(2j-2)xVref)/4, said second sequence of analog voltages being representative of the conversion of the even bits;
  wherein $V_i'$ and $V_p'$ are the respective analog voltages $V_i$ and $V_p$, which were generated in the previous step,
- in response to said detection of an odd bit being the most significant bit, generating (118) an analog voltage Vi satisfying the relationship Vi = Vi′ + MSBxVref; and generating (117) an analog voltage Vp satisfying the relationship Vp = (Vp′ + B(2j-2)xVref)/4,
- multiplying (119) said analog voltage Vp by 2.
- adding (219) said analog voltage Vp to said analog voltage Vi in order to provide an analog representation of said digital word.

**2.** A digital-to-analog conversion method for converting an N-bit digital word (B(N-1)B(N-2)...N1B0 into its analog representation, with N being an odd integer, said digital word consisting of a first sequence of odd bits B(2j-1) and a second sequence of even bits B(2j-2), where j=1 to (N+1)/2, the conversion of an odd bit and the conversion of an even bit being parallely performed, said method involving the steps of:

- detecting (213) whether the even bit (B(2j-2) among the two bits being parallely converted is the Most Significant Bit (MSB),
- as long as the even bit to be converted is not the most significant bit, generating (216) a first sequence of analog voltages Vi satisfying the following relationship Vi=(Vi′ + B(2j-1)xVref)/4, said first sequence of analog values being representative of the conversion of the even bits, and Vref being a reference voltage; and parallely generating (114) a second sequence of analog voltages Vp satisfying the relation ship Vp = ( Vp′ + B(2j-2)xVref)/4, said second sequence of analog voltages being representative of the conversion of the even bits;
  wherein $V_i'$ and $V_p'$ are the respective analog voltages $V_i$ and $V_p$, which were generated in the previous step,
- in response to said detection of an an even bit being the most significant bit, generating (218) an analog voltage Vi satisfying the relationship Vi = Vi′x2 and generating (217) an analog voltage Vp satisfying the relationship Vp = Vp′ + MSBxVref,
- adding (219) said analog voltage Vp to said analog voltage Vi in order to provide an analog representation of said digital word.

## Patentansprüche

**1.** Digital-Analog-Umwandlungsverfahren zum Umwandeln eines N Bits umfassenden Wortes (B(N-1)B(N-2)...B1B0) in dessen analoge Darstellung, wobei N eine gerade ganze Zahl ist, wobei das digitale Wort aus einer ersten Folge ungerader Bits B(2j-1) und einer zweiten Folge gerader Bits B(2j-2) besteht, worin J = 1 bis N/2 ist, wobei die Umwandlung eines ungeraden Bits und die Umwandlung eines geraden Bits parallel durchgeführt werden, wobei das Verfahren folgende Schritte aufweist:

- Detektieren (113), ob das ungerade Bit (B(2j-1)) unter den zwei parallel umgewandelten Bits das höchstwertige Bit (MSB) ist,
- Erzeugen (115) einer ersten Folge analoger Spannungen Vi, die die folgende Beziehung Vi = (Vi′ + B(2j-1) x Vref)/4 erfüllen, wobei die erste Folge analoger Werte das Ergebnis der Umwandlung der ungeraden Bits ist und Vref eine Referenzspannung ist, und paralleles Erzeugen (114) einer zweiten Folge analoger Spannungen Vp, die die Beziehung Vp = (Vp′ + B(2j-2) x Vref)/4 erfüllen, wobei die zweite Folge analoger Spannungen das Ergebnis der Umwandlung der geraden Bits ist, worin Vi′ und Vp′ die analogen Spannungen Vi und Vp sind, die im vorausgegangenen Schritt erzeugt worden sind,
- Erzeugen (118) einer analogen Spannung Vi, die der Beziehung Vi = Vi′ + MSB x Vref genügt, als Reaktion auf das Detektieren eines ungeraden Bits, welches das höchstwertige Bit ist, und Erzeugen (117) einer analogen Spannung Vp, die der Beziehung Vp = (Vp′ + B(2j-2) x Vref)/4 genügt,
- Multiplizieren (119) der analogen Spannung Vp mit 2,
- Addieren (219) der analogen Spannung Vp zu der analogen Spannung Vi, um eine analoge Darstellung des digitalen Wortes zu liefern.

2. Digital-Analog-Umwandlungsverfahren zum Umwandeln eines N Bits umfassenden Wortes B(N-1)B(N-2)...B1B0) in dessen analoge Darstellung, wobei N eine ungerade ganze Zahl ist, wobei das digitale Wort aus einer ersten Folge ungerader Bits B(2j-1) und einer zweiten Folge gerader Bits B(2j-2) besteht, worin j = 1 bis (N+1)/2 ist, wobei die Umwandlung eines ungeraden Bits und die Umwandlung eines geraden Bits parallel ausgeführt wird, wobei das Verfahren folgende Schritte aufweist:
   - Detektieren (213) ob das gerade Bit (B(2j-2)) unter den zwei parallel umgewandelten Bits das höchstwertige Bit (MSB) ist,
   - Solange das umzuwandelnde gerade Bit nicht das höchstwertige Bit ist, Erzeugen (216) einer ersten Folge analoger Spannungen Vi, die die folgende Beziehung Vi = (Vi′ + B(2j-1) x Vref)/4 erfüllen, wobei die erste Folge analoger Werte das Ergebnis der Umwandlung der geraden Bits ist und Vref eine Referenzspannung ist, und paralleles Erzeugen (215), einer zweiten Folge analoger Spannungen Vp, die die Beziehung Vp = (Vp′ + B(2j-2) x Vref)/4 erfüllen, wobei die zweite Folge analoger Spannungen das Ergebnis der Umwandlungen der geraden Bits ist, worin Vi′ und Vp′ die analogen Spannungen Vi und Vp sind, die im vorausgegangenen Schritt erzeugt worden sind,
   - Erzeugen (218) einer analogen Spannung Vi, die der Beziehung Vi = Vi x 2 genügt, und Erzeugen (217) einer analogen Spannung Vp, die der Beziehung Vp = Vp′ + MSB x Vref genügt, als Reaktion auf das Detektieren eines geraden Bits, welches das höchstwertige Bit ist,
   - Addieren (219) der analogen Spannung Vp zu der analogen Spannung Vi, um eine analoge Darstellung des digitalen Wortes zu erhalten.

## Revendications

1. Procédé de conversion numérique/analogique destiné à convertir un mot numérique à N bits (B(N-1)B(N-2)...N1B0) en sa représentation analogique, avec N étant un nombre entier pair, le dit mot numérique étant constitué d'une première séquence de bits impairs B(2j-1) et d'une seconde séquence de bits pairs B(2j-2), où j = 1 à N/2, la conversion d'un bit impair et la conversion d'un bit pair étant effectuées en parallèle, ledit procédé impliquant les étapes consistant à :
   - détecter (113) si le bit impair (B(2j-1)) entre les deux bits étant convertis en parallèle est le bit de poids fort (MSB),
   - tant que le bit impair qui doit être converti n'est pas le bit de poids fort, produire (115) une première séquence de tensions analogiques Vi satisfaisant la relation suivante Vi = $(V_i' + B_{2j-1} x V_{ref})/4$, ladite première séquence de valeurs analogiques étant représentative de la conversion des bits impairs et Vref étant une tension de référence, et produire en parallèle (114) une seconde séquence de tensions analogiques Vp satisfaisant la relation Vp = $(V_p' + B_{2j-2}\ x\ V_{ref})/4$, ladite seconde séquence de tensions analogiques étant représentative de la conversion des bits pairs, dans laquelle $V_i'$ et $V_p'$ sont les tensions analogiques respectives $V_i$ et $V_p$ qui ont été produites à l'étape précédente,
   - en réponse à ladite détection d'un bit impair étant le bit de poids fort, produire (118) une tension analogique Vi satisfaisant la relation $V_i = V_i' + MSB\ x\ V_{ref}$ et produire (117) une tension analogique $V_p$ satisfaisant la relation $V_p = (V_p' +_{2j-2}\ x\ V_{ref})/4$,
   - multiplier (119) ladite tension analogique $V_p$ par 2,
   - ajouter (2/9) ladite tension analogique $V_p$ à ladite tension analogique $V_i$ afin de délivrer une représentation analogique dudit mot numérique.

2. Procédé de conversion numérique/analogique destiné à convertir un mot numérique à N bits (B(N-1)B(N-2)...N1B0) en sa représentation analogique, avec N étant un nombre entier impair, ledit mot numérique étant constitué d'une première séquence de bits impairs B(2j-1) et une seconde séquence de bits pairs B(2j-2), où J = 1 à (N+1)/2, la conversion d'un bit impair et la conversion d'un bit pair étant effectuées en parallèle, ledit procédé impliquant les étapes consistant à :
   - détecter (213) si le bit pair (B(2j-2)) entre les deux bits étant convertis en parallèle est le bit de poids fort (MSB),
   - tant que le bit pair qui doit être converti n'est pas le bit de poids fort, produire (216) une première séquence de tension analogique $V_i$ satisfaisant la relation suivante $V_i = (V_i' + B_{(2j-1)} x V_{ref})/4$, ladite première séquence de valeurs analogiques étant représentative de la conversion des bits pairs et $V_{ref}$ étant une tension de référence, et produire en parallèle (114) une seconde séquence de tensions analogiques $V_p$ satisfaisant la relation $V_p = (V_p' + B_{(2j-2)} \times V_{ref})/4$, ladite seconde séquence de tensions analogiques étant représentative de la conversion des bits pairs, dans laquelle $V_i'$ et $V_p'$ sont les tensions analogiques respectives Vi et Vp qui ont été produites dans l'étape précédente,

- en réponse à ladite détection d'un bit pair étant le bit de poids fort, produire (218) une tension analogique $V_i$ satisfaisant la relation $V_i = V_i' X 2$ et produire (217) une tension analogique Vp satisfaisant la relation $V_p = V_p' + MSBxV_{ref}$,
- additionner (219) ladite tension analogique $V_p$ à ladite tension analogique $V_i$ afin de délivrer une représentation analogique dudit mot numérique.

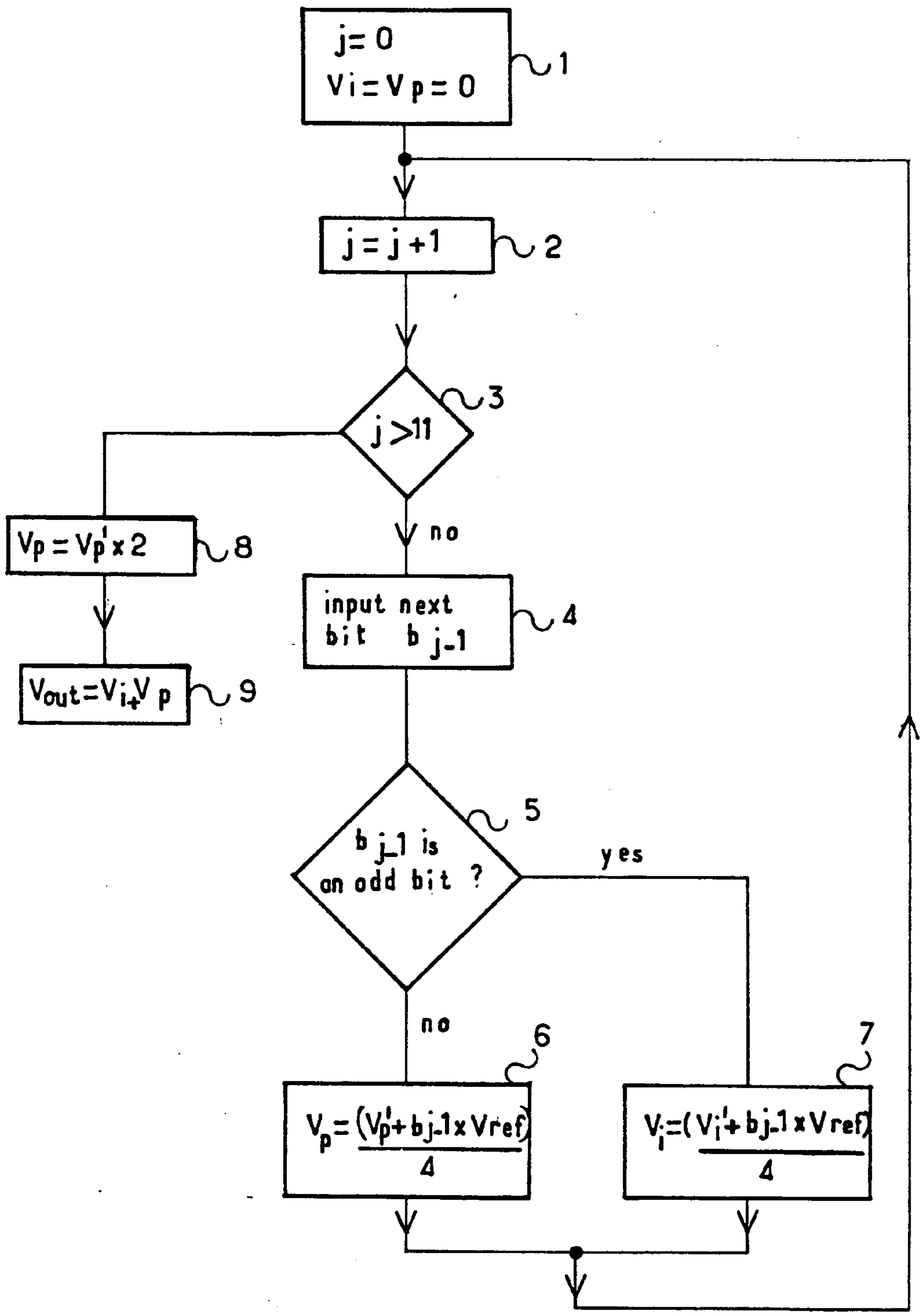


$$V_{out} = \frac{Vref}{2^{12}} \times (b_0 \times 2^0 + b_1 \times 2^1 + b_2 \times 2^2 + \dots\dots + b_{11} \times 2^{11})$$

FIG.1

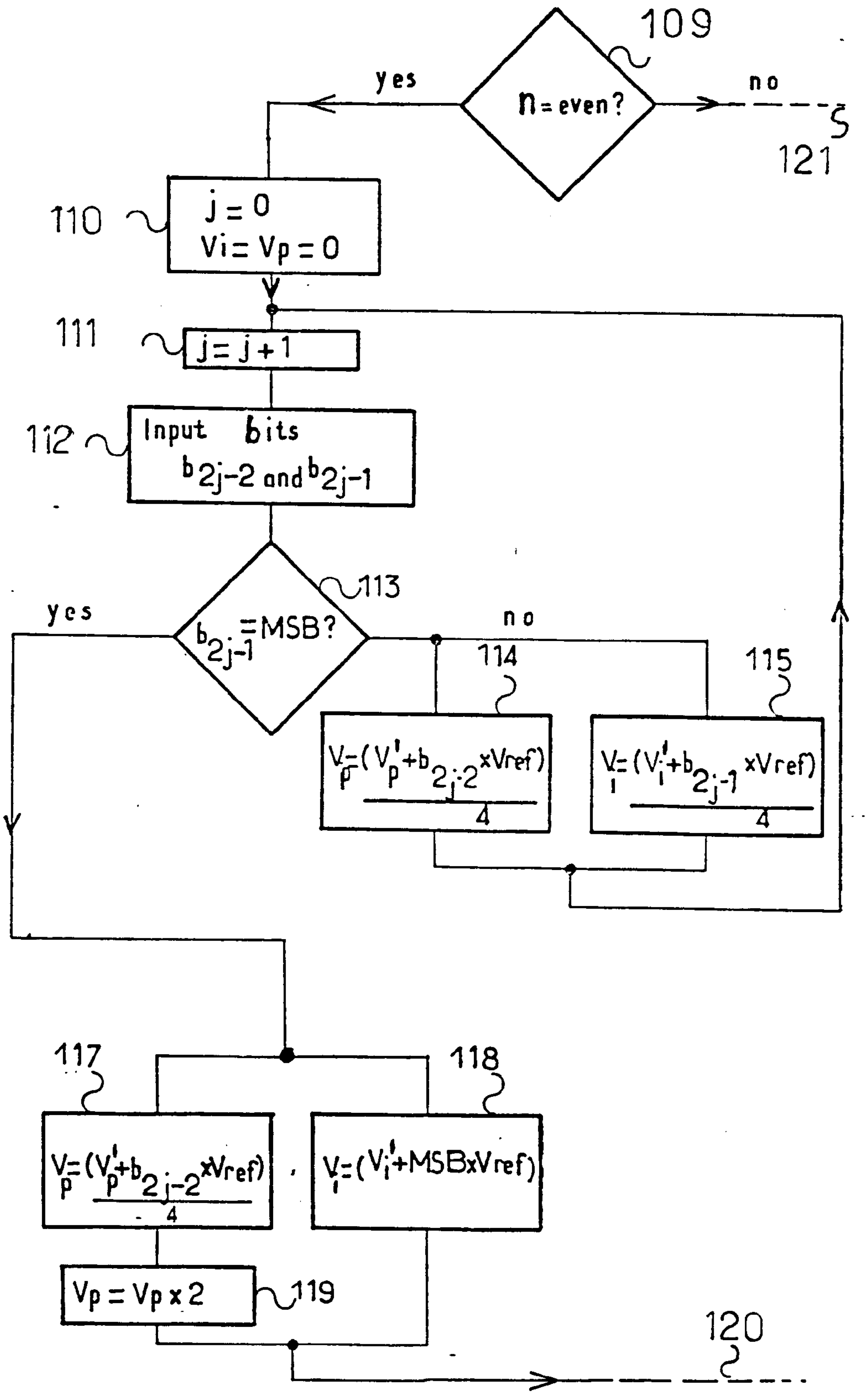
109
n = even?
yes
no
121
110
j = 0
Vi = Vp = 0
111
j = j + 1
112
Input bits
b2j-2 and b2j-1
113
b2j-1 = MSB?
yes
no
114
115
Vp = (V'p + b2j-2 x Vref) / 4
Vi = (V'i + b2j-1 x Vref) / 4
117
118
Vp = (V'p + b2j-2 x Vref) / 4
Vi = (V'i + MSB x Vref)
Vp = Vp x 2
119
120

FIG. 2a

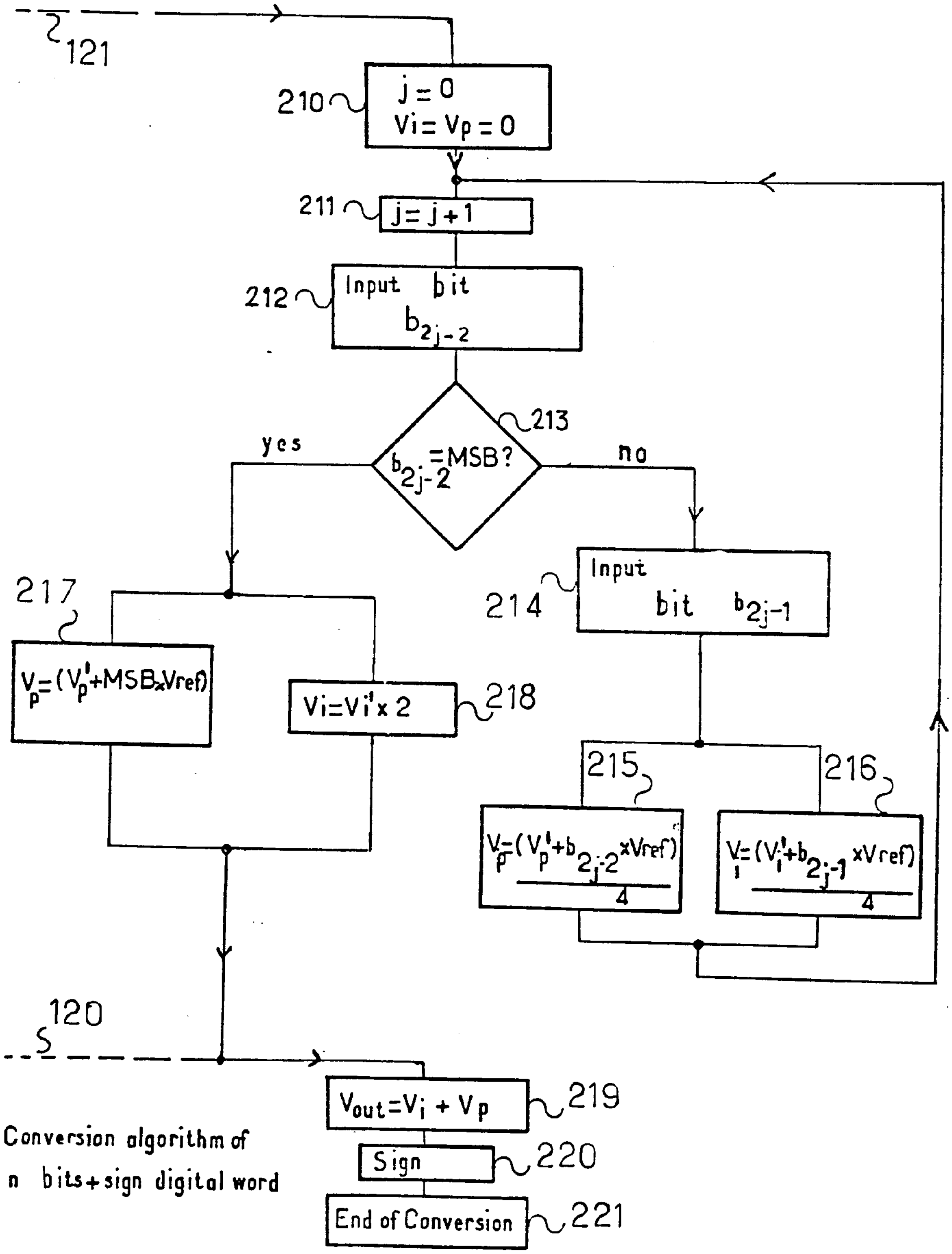


$$Vout = \frac{Sign \times Vref}{2^{n-1}} \times ( b_{n-1} \times 2^{n-1} + b_{n-2} \times 2^{n-2} + ...... + b_0 \times 2^0 )$$

FIG. 2b

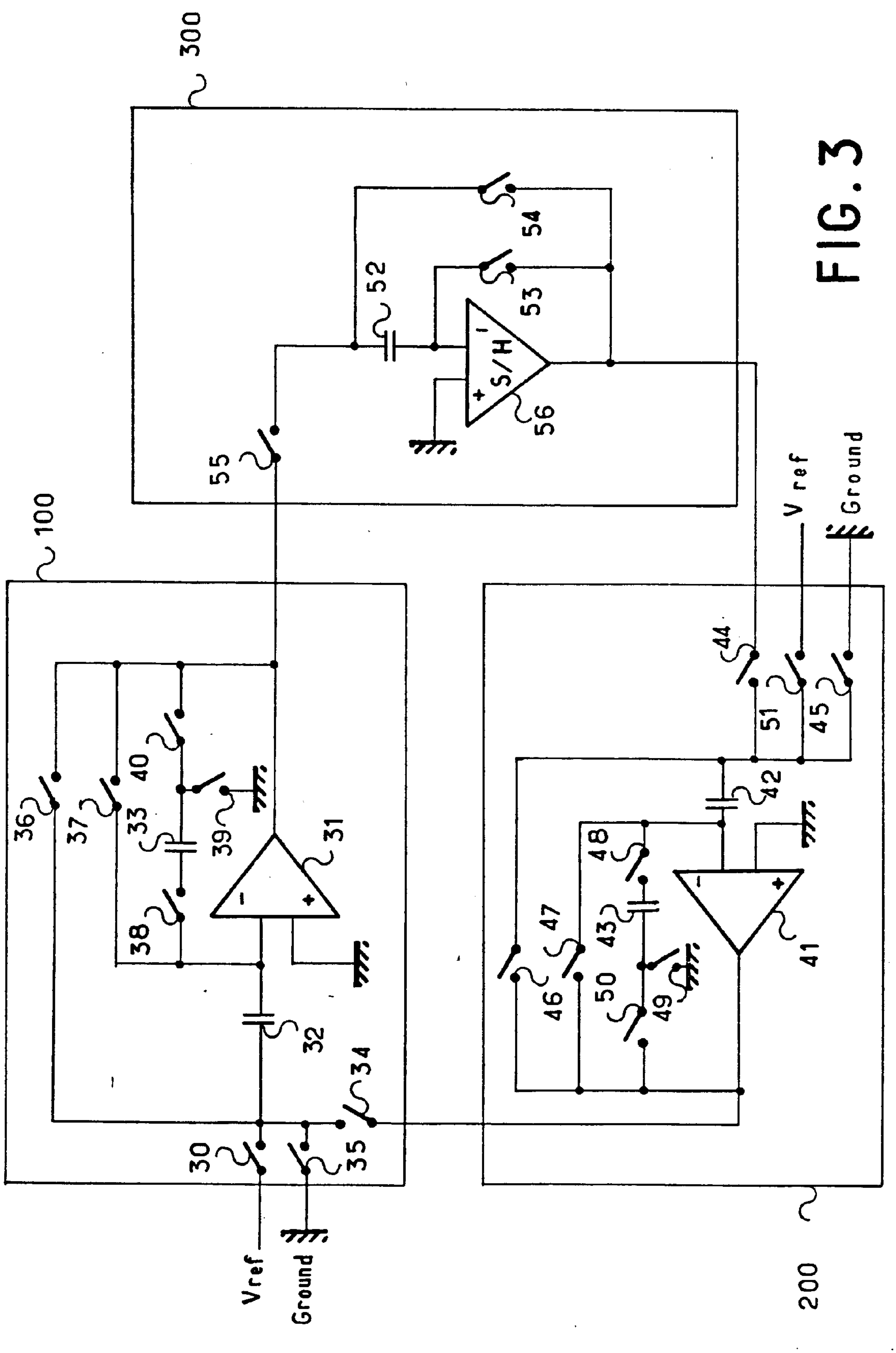
300
100
200
S/H
Vref
Ground
30
31
32
33
34
35
36
37
38
39
40
41
42
43
44
45
46
47
48
49
50
51
52
53
54
55
56

FIG. 3

| | block 100 | | | | | | | | block 200 | | | | | | | | block 300 | | |
|---|---|---|---|---|---|---|---|---|---|---|---|---|---|---|---|---|---|---|---|
| Step | 30 | 34 | 35 | 36 | 37 | 38 | 39 | 40 | 44 | 45 | 46 | 47 | 48 | 49 | 50 | 51 | 53 | 54 | 55 |
| 401 | $b_0$ | 0 | $\overline{b_0}$ | 0 | 1 | 1 | 1 | 0 | 0 | $\overline{b_1}$ | 0 | 1 | 1 | 1 | 0 | $B_1$ | 0 | 0 | 0 |
| 402 | 0 | 0 | 0 | 1 | 0 | 1 | 0 | 1 | 0 | 0 | 1 | 0 | 1 | 0 | 1 | 0 | 0 | 0 | 0 |
| 403 | 0 | 0 | 1 | 0 | 1 | 0 | 0 | 1 | 0 | 1 | 0 | 1 | 0 | 0 | 1 | 0 | 0 | 0 | 0 |
| 404 | 0 | 0 | 0 | 1 | 0 | 1 | 0 | 1 | 0 | 0 | 1 | 0 | 1 | 0 | 1 | 0 | 1 | 0 | 1 |
| 405 | 0 | 1 | 0 | 0 | 1 | 1 | 1 | 0 | 0 | 0 | 1 | 0 | 1 | 0 | 1 | 0 | 0 | 1 | 0 |
| 406 | 0 | 0 | 1 | 0 | 0 | 1 | 0 | 1 | 1 | 0 | 0 | 1 | 1 | 1 | 0 | 0 | 0 | 1 | 0 |
| 407 | $b_{2j-1}$ | 0 | $\overline{b_{2j-1}}$ | 0 | 1 | 0 | 0 | 1 | 0 | 1 | 0 | 0 | 1 | 0 | 1 | 0 | 0 | 0 | 0 |
| 408 | 0 | 0 | 0 | 1 | 0 | 1 | 1 | 0 | 0 | $\overline{b_{2j-2}}$ | 0 | 1 | 0 | 0 | 1 | $b_{2j-2}$ | 1 | 0 | 1 |
| 409 | 0 | 1 | 0 | 0 | 1 | 1 | 1 | 0 | 0 | 0 | 1 | 0 | 1 | 1 | 0 | 0 | 0 | 1 | 0 |
| 410 | 0 | 0 | 0 | 1 | 0 | 1 | 0 | 1 | 1 | 0 | 0 | 1 | 1 | 1 | 0 | 0 | 0 | 1 | 0 |
| 411 | 0 | 0 | 1 | 0 | 1 | 0 | 0 | 1 | 0 | 0 | 1 | 0 | 1 | 0 | 1 | 0 | 0 | 0 | 0 |
| 412 | 0 | 0 | 0 | 1 | 0 | 1 | 0 | 1 | 0 | 1 | 0 | 1 | 0 | 0 | 1 | 0 | 1 | 0 | 1 |
| a | 0 | 1 | 0 | 0 | 1 | 1 | 1 | 0 | 0 | 0 | 1 | 0 | 1 | 0 | 1 | 0 | 0 | 1 | 0 |
| b | 0 | 0 | 1 | 0 | 0 | 1 | 0 | 1 | 1 | 0 | 0 | 1 | 1 | 1 | 0 | 0 | 0 | 1 | 0 |
| c | MSB | 0 | $\overline{MSB}$ | 0 | 1 | 0 | 0 | 1 | 0 | 1 | 0 | 0 | 1 | 0 | 1 | 0 | 0 | 1 | 0 |
| d | 0 | 0 | 1 | 0 | 0 | 1 | 0 | 1 | 1 | 0 | 0 | 1 | 0 | 0 | 1 | 0 | 0 | 1 | 0 |
| e | 0 | 1 | 0 | 0 | 1 | 0 | 0 | 1 | 0 | 0 | 1 | 0 | 1 | 1 | 0 | 0 | 0 | 0 | 0 |
| f | 0 | 0 | 0 | 1 | 0 | 1 | 1 | 0 | 0 | 0 | 0 | 0 | 0 | 0 | 0 | 0 | 0 | 0 | 0 |

FIG. 4

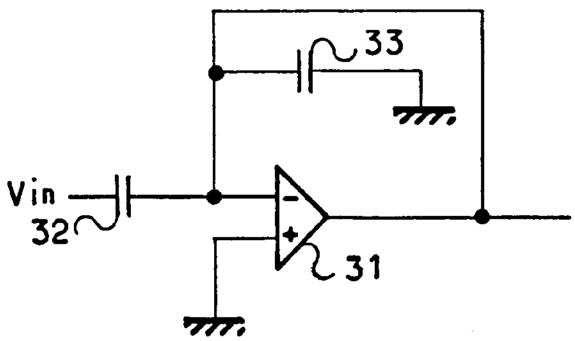


FIG 5.a PHASE 1

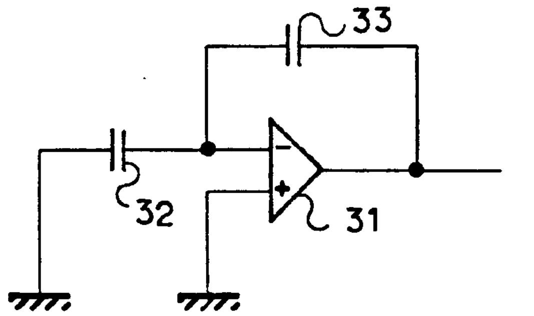


FIG 5.b PHASE 2

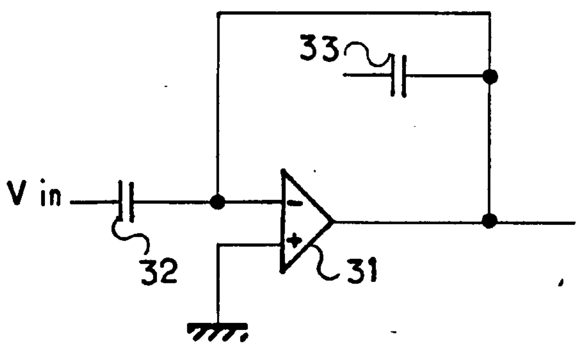


FIG 5.c PHASE 3

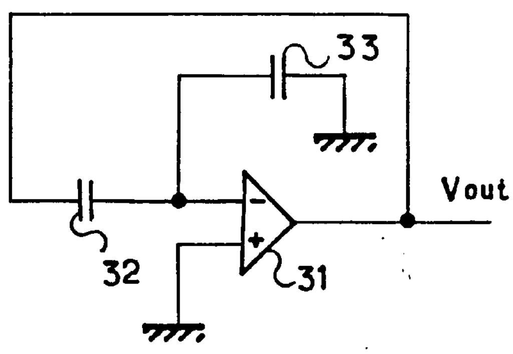


FIG 5.d PHASE 4

Vout = 2 x V in

FIG.5

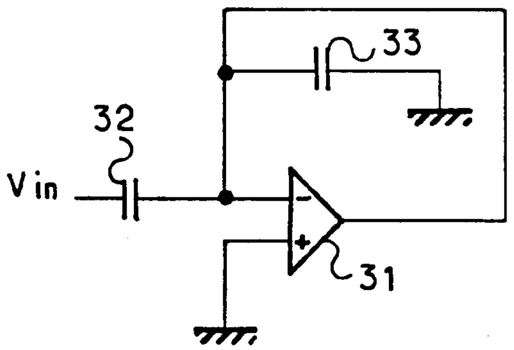


FIG 6.a PHASE 1

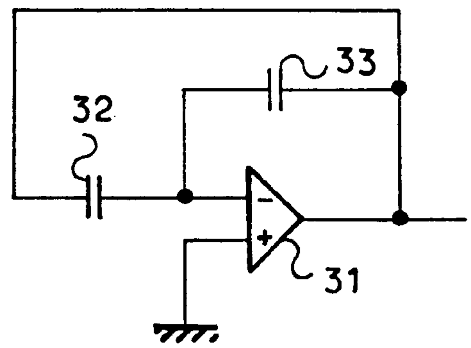


FIG 6.b PHASE 2

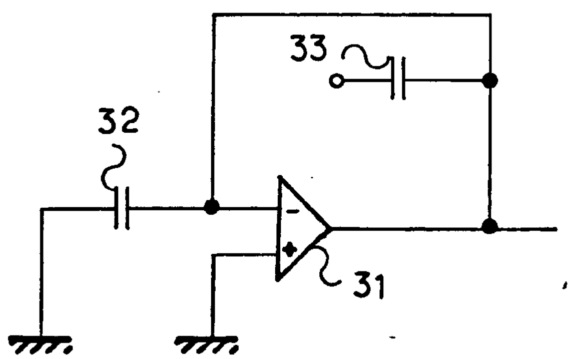


FIG 6.c PHASE 3

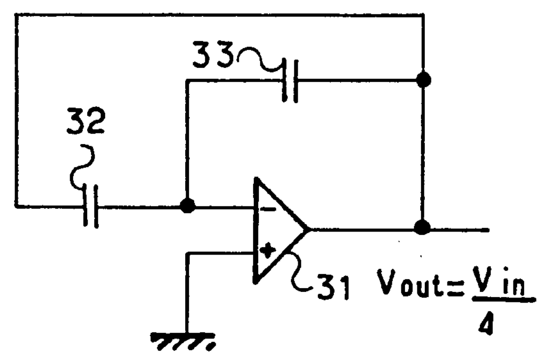


FIG 6.d PHASE 4

FIG. 6

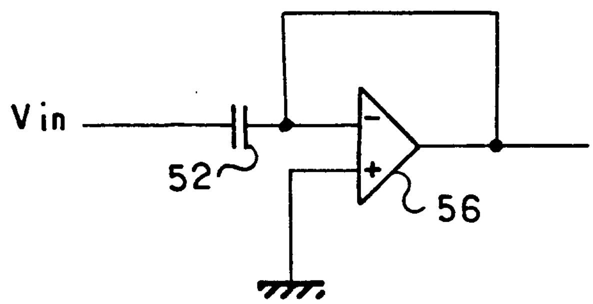


FIG 7.a PHASE 1

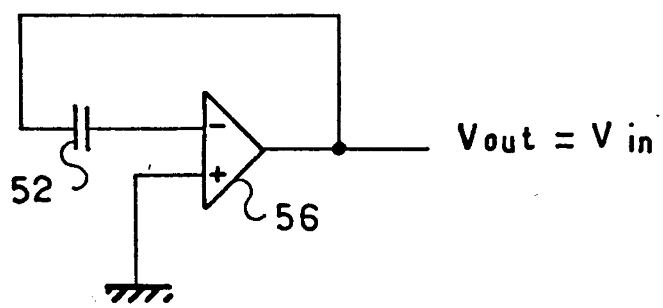


FIG 7.b PHASE 2

FIG. 7